Europäisches Patentamt

European Patent Office

Office européen des brevets

(11) Publication number: **0 256 183 B1**

# EUROPEAN PATENT SPECIFICATION

(45) Date of publication of patent specification: **06.07.94**   (51) Int. Cl.⁵: **G01R 19/02**, G01R 19/25, B23K 11/24

(21) Application number: **86306314.5**

(22) Date of filing: **15.08.86**

(54) RMS current determination by sampling current differential.

(43) Date of publication of application:
**24.02.88 Bulletin 88/08**

(45) Publication of the grant of the patent:
**06.07.94 Bulletin 94/27**

(84) Designated Contracting States:
**DE FR GB IT**

(56) References cited:
**DE-A- 1 011 065**
**FR-A- 978 684**
**US-A- 3 034 057**
**US-A- 3 289 079**
**US-E- 31 774**

**INTERNATIONAL JOURNAL OF ELECTRONICS, vol. 59, no. 2, août 1985, pages 199-210, London, GB; S.M.R.TAHA et al.: "Direct digital RMS measuring device"**

(73) Proprietor: **Dynamic Systems Inc.**
**R.D. 5, Box 85**
**Troy New York 12180(US)**

(72) Inventor: **Ferguson, Hugo Stanley**
**R.D. 2, Box 9**
**Averill Park New York(US)**
Inventor: **Hollinger, David Lee**
**6 Donna Lynn Drive**
**East Greenbush New York(US)**

(74) Representative: **McCallum, William Potter**
**Cruikshank & Fairweather**
**19 Royal Exchange Square**
**Glasgow G1 3AE Scotland (GB)**

**Description**

The invention relates to root-mean-square (RMS) measurements and, more particularly, to one step RMS measurements of first differential waveforms.

The measurement of root-mean-squared (RMS) values in both AC and DC waveforms has been substantially simplified in recent years through the development of RMS microchips, such as the BURRBROWN 4340 and 4341 True RMS-to-DC conversion integrated circuits. These units, which are each a single microchip, provide a DC output equal to the RMS value of the input waveform. When the time over which the measurement is being made is long compared to the individual perturbations of the waveform, the averaging time is substantial and the output is a very precise measurement. However, as the averaging time is shortened, and the duration of each perturbation approaches the overall measurement time, the measured value becomes less accurate.

Previously, the RMS measurement of waveforms having a short time duration and only a few perturbations was made using special dedicated RMS circuits. U.S. Patent Nos. 3,201,688 and 3,289,079, which are incorporated herein by reference, disclose systems for measuring waveforms of a short duration where the base frequency of the perturbations is known and fixed. Using such circuits, RMS measurements can be made on a single perturbation or pulse, while relating the RMS value to waveforms having a plurality of similar perturbations with the same fixed base frequency. However, when the base frequency of the perturbations is not known or is variable, the circuits disclosed in these patents are not suitable. Additionally, such circuits operate properly only when the waveform to be measured is sinusoidal, or nearly sinusoidal.

The measurement of RMS values of current in high current heating and welding circuits requires special consideration. The signal may typically be measured by using a high current shunt, a Hall effect transducer, a current transformer, or an air core toroid coil (or Rogowski coil or belt).

For example, U.S. Patent No. 3034057, discloses an analog system for measuring the RMS value of AC welding current. This system relies on measuring the welding current using a toroidal pickoff coil, then integrating a voltage produced by the coil to yield a voltage proportional to the current. This latter voltage is then successively squared, amplified and integrated to produce a result. Unfortunately, this system is limited to measuring welding current that only contains periodic current pulses. This system is simply unable to limit its measurements to encompass any one single pulse of welding current. As such, this system is of essentially no use in modern high current welders where only a small number of such pulses is used to form a weld. In such welders, the total number of these pulses and the duration of each of these pulses must be separately controlled. To accomplish this, the RMS value of each single pulse of welding current must be accurately determined. By contrast, in the present invention hereinafter described sampling is synchronised with the start of each pulse and sampling continues throughout a half-cycle measurement period of the power line signal regardless of when a pulse being measured stops with that period providing an accurate RMS value for each separate welding pulse.

In addition, U.S. Reissue Patent No. 31,774 discloses a system for measuring a value of time integral of a function of a variable. This system relies on sampling the function at a periodic, though asynchronous, frequency that is not a harmonic or sub-harmonic of the frequency of the sampled function. All the resulting sampled values are then summed during a period of the sampled function to yield a time integral value. Unfortunately, since this system relies on using asynchronous sampling, then any resulting integrated value is likely to be in error, perhaps grossly so, for non-periodic, particularly pulsatile functions, such as half-cycles of AC current as are commonly used in AC welders. This error will arise due to the likely inclusion of an excessive number of samples, such as after a half-cycle pulse has terminated, in determining the value of the integral. The invention system advantageously eliminates this error.

All of these methods have limitations. The high current shunt disturbs the circuit by increasing the physical size of the system. The Hall effect transducer is position sensitive, temperature sensitive and has a limited linear range. The high current transformer is expensive, bulky, has a limited linear range, and disturbs the circuit. The air core toroid coil, however, is economical, small in size, easy to locate in the circuit, disturbs the circuit very little, is linear over a very large range but, however, provides an output proportional to the first differential with respect to time of the current in the monitored circuit. Therefore, in using air core toroid coils, it is usually necessary to integrate the first differential waveform generated by the air core toroid coil in order to obtain the current waveform before the RMS value is determined.

There are many instruments which measure RMS values of short duration AC pulses of high current at power line frequency using an air core toroid coil to obtain an input signal. In all cases, some form of electrical integration is used prior to deriving the RMS value. The only exception occurs where the waveform is a pure sine wave yielding a cosine wave output from the air core toroid coil. In this case, the differential is equal to the initial waveform except for a shift in phase.

There are generally two types of integrators, passive and active, each of which have advantages and limitations. Passive integrators are very stable but have very low output. Active integrators have high output, some DC drift, limited frequency range, and, when used for integration of signals with very low frequencies, often have an output that has low frequency oscillation resulting in a "rocking" output. In order to obtain RMS measurements, active integrators are primarily used followed by some form of dedicated RMS integrated circuit.

In most presently used high current systems, the current level is controlled by using a high current silicon controlled rectifier (SCR) switch to turn the current system on a short time after each half cycle of power line voltage has begun. This system, however, yields a current output for less than a full half cycle for each half power line voltage cycle. Since the measured RMS current value is used in controlling the current to the circuit, a device that generates RMS current values must be accurate. In order to obtain accurate RMS current values, the current must be measured for the whole half cycle, not merely that portion of the cycle when the current is not equal to zero. If the RMS current is determined during a half cycle only when the current is non-zero, the resultant RMS current value is greater than the true RMS current value, and accurate control of the current through the circuit cannot be achieved.

In the one step RMS system of the present invention, an air core toroid coil is used to measure the first differential with respect to time of a current signal waveform. Since the output from the air core toroid coil (or Rogowski coil or belt) is the first differential with respect to time of the current waveform, it is necessary to integrate this signal to obtain the current waveform. In the one step RMS system of the present invention, the current waveform is not electrically but mathematically integrated, thus eliminating all the deficiencies associated with the use of active and passive electrical integrators, including the limitation of operating frequency range. The use of the air core toroid coil provides all the advantages associated with the use of this particular transducer. The elimination of the electrical integration step to obtain the current waveform reduces the cost of the system, allows the measurement of RMS values on short time DC, time varying DC, and any frequency AC signals, allows the RMS measurement on any wave shape, and eliminates the rocking problems associated with low frequency operation of active integrators.

Accordingly, the RMS system of the present invention provides a simple and inexpensive system to obtain the RMS value of analog current waveforms which can have low frequencies, few perturbations, high amplitude, or a short time duration. Additionally, the present invention provides an RMS value of a waveform in one step directly from the first differential of the waveform without employing the second step of electrically integrating the first differential waveform. Furthermore, the RMS values obtained are independent of the time base of the measured waveform.

These and other objects are achieved in accordance with the present invention by determining the RMS value directly from the first differential waveform generated by an air core toroid coil without first electrically obtaining the current waveform. The RMS value of a waveform or part thereof is determined by converting the signal into digital form and by sampling the first differential of the waveform generated by the air core toroid coil. The sampling and conversion is done N times per piece of waveform or time period being analyzed. As each sampling and conversion is completed, the digital number, representing the instantaneous value of the amplitude of the differential waveform, is used to determine the instantaneous value of the current at that time. This current value is squared and added to the sum of the prior squared values. Each squared value is summed until N samplings and conversions have been made. At this point, the final total is divided by N, and the square root is then taken to obtain the RMS value. Using this procedure, there is no limitation placed on N, which may range from one to a very large number. Additionally, the waveform may have any configuration or frequency.

In accordance with a specific embodiment of the present invention, the high current flow of a single phase resistance welding machine is measured by an air core toroid coil. The output of the coil is applied directly to the input of an Analog-to-Digital (A/D) converter contained within a microcontroller large scale integrated circuit. The microcontroller is a complete microprocessor system including an internal timer and input/output (I/O) ports. The internal timer of the microcontroller causes the A/D converter to operate at predetermined time intervals. Each time the A/D converter completes a conversion, the digital word is stored in random access memory (RAM). The value is then used to determine the instantaneous value of the current. After squaring, the squared value is added to the prior stored sum of squared values and stored in RAM. When N conversions have been completed, the last sum of squared values is divided by N, and the square root of the result is taken thus resulting in the RMS current. In the case of the single phase welder, the N count is synchronized to the line voltage used to operate the welder. Since during a weld pulse the current generally flows during only part of each half cycle, some of the instantaneous current values for each half cycle will be zero. However, since N is chosen to encompass the entire half cycle, the

3

RMS value calculated will be based on the whole half cycle time period not merely a part of the half cycle time period. By using the entire half cycle time period, measurements made on only a small fraction of a half cycle will correspond to measurements made on longer weld pulses of more than one half cycle.

Another feature of the present invention is that the number of samplings N and the time between samplings of the differential signal can be independent of the particular waveform. The choice of N determines the resolution of the calculated values. As N is increased and the time between samplings is reduced, the RMS value approaches the amplitude of the current waveform for the short evaluation period. The choice of the time period between each of the N samplings determines the period over which the RMS value is obtained. Thus, the RMS value for any part of a waveform comprised of pulses of long duration may be determined.

These and other objects, features and advantages of our invention will be more readily apparent from the following detailed description of an embodiment of the invention in which:

Fig. 1 is a schematic diagram of an embodiment of the one step RMS system used with a single phase resistance welder;

Fig. 2 is a flow diagram describing the initialization procedure used in an embodiment of the one step RMS system of the present invention;

Fig. 3 is a flow-diagram of the time based interrupt service routine of an embodiment of the one step RMS system of the present invention; and

Fig. 4 is a graphical representation of one cycle of a typical input waveform and the first differential of this waveform analyzed by the one step RMS system of the present invention.

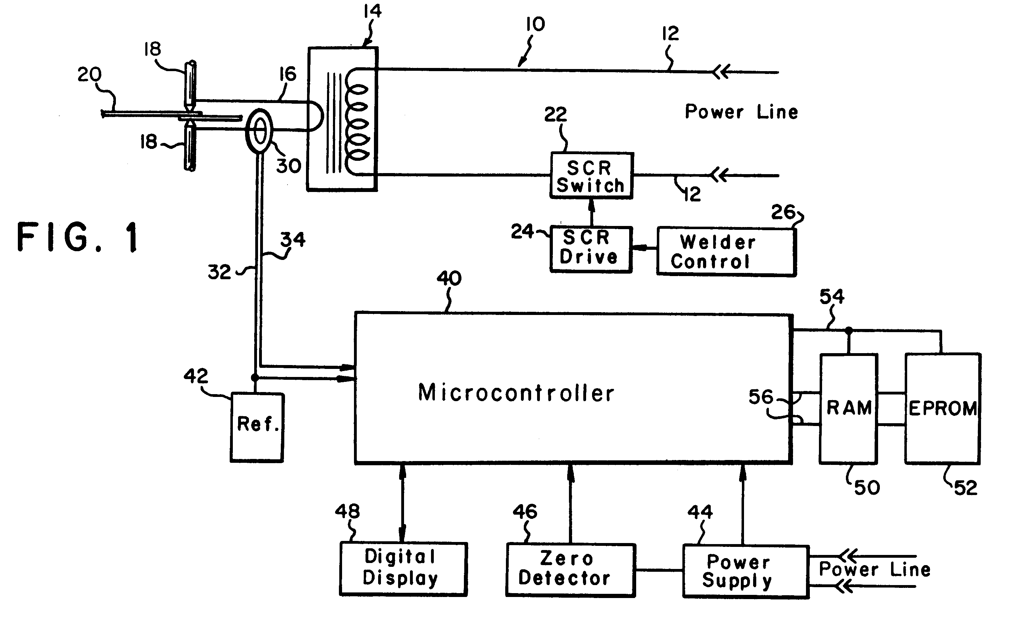

Fig. 1 depicts a schematic diagram of an embodiment of the one step RMS system of the present invention used with a single phase resistance welder, an air core toroid coil, and a microcontroller which embodies the teachings of the present invention. The present invention can also be used to measure RMS current values of other systems such as, for example, electrical heating systems and power lines.

Referring to Fig. 1, a single phase resistance welder 10 is provided with electric power by a pair of power lines 12. A transformer 14 steps down the power line voltage and increases the electrode current which is provided to secondary circuit 16 and electrodes 18 which heat workpieces 20. Since the electrode current passing through secondary circuit 16 is the current that is to be measured and controlled, the RMS value of this current must be determined. The power line voltage provided to transformer 14 is controlled by SCR switch 22, drive 24, and welder control 26. Power lines 12, transformer 14 and SCR switch 22 comprise a primary circuit. An air core toroid coil 30 (also known as a Rogowski coil or belt) surrounds a portion of secondary circuit 16 and may be located at any point in secondary circuit 16. The electrode current typically has a fixed current frequency and a fixed current period. The changes in the electrode current passing through secondary circuit 16 induces an electro-magnetic force (EMF) within the toroid of air core toroid coil 30. This EMF causes a differential current signal to be generated by the coil of air core toroid coil 30 which is proportional to the rate of change of the magnetic field induced by the electrode current flowing in secondary circuit 16. Thus the differential current passing through the coil of air core toroid coil 30 is proportional to the first differential with respect to time of the electrode current passing through secondary circuit 16. Alternatively, other devices which produce a first differential current signal can be used instead of an air core toroid coil.

The signal from the air core toroid coil 30 is fed through lines 32 and 34 to the input of microcontroller 40. A reference system 42 provides a voltage equal to one half of the input signal excursion allowed by microcontroller 40. Illustratively, microcontroller 40 is an MCS®-96 (8096) microcontroller or an MCS®-97 (8097) microcontroller manufactured by the Intel Corporation of Santa Clara, California although other microcontrollers or other similarly functioning devices can be used. Microcontroller 40 typically has an input signal range of about 0 to about 5 volts. Accordingly, reference system 42 is set at about 2.5 volts so that signals of equal positive and negative amplitude may be measured by microcontroller 40. The input signal on lines 32 and 34 can alternatively be rectified to a single polarity thus eliminating the need for reference system 42. This alternative would, however, increase the analog to digital conversion range by one bit and may add some inaccuracy and introduce some DC drift into the system.

Supporting the operation of the microcontroller 40 is power supply 44 and associated zero crossing detector 46. Zero crossing detector 46 provides a pulse of length equal to the time length of one half cycle of the power line frequency. This signal is used to initiate the correct time base for calculating the RMS current of secondary circuit 16. Digital data display 48 is used to display the RMS current value calculated by microcontroller 40. There are many types of digital displays suitable for operation from the microcontroller port; however, the resolution of the digital display 48 is to be chosen to adequately resolve the data gathered by microcontroller 40.

4

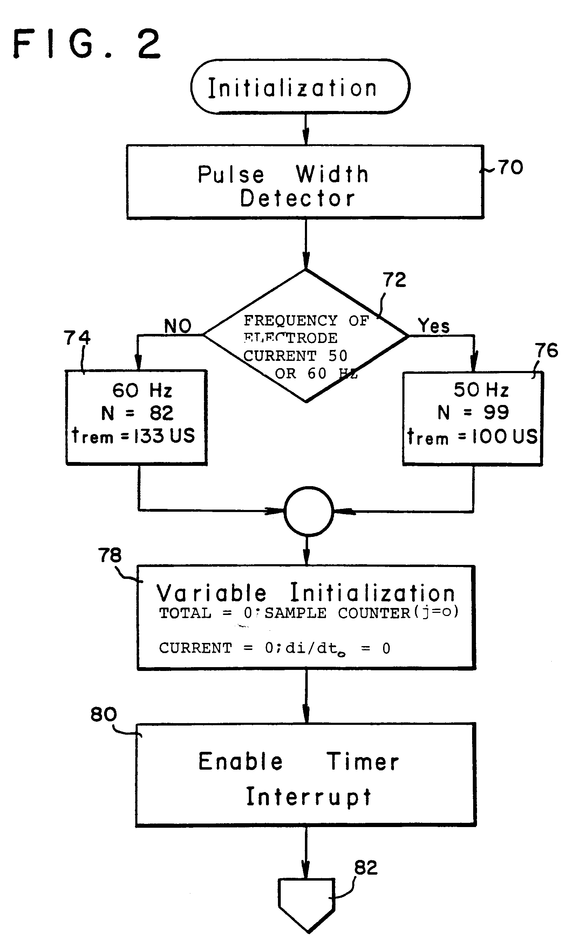

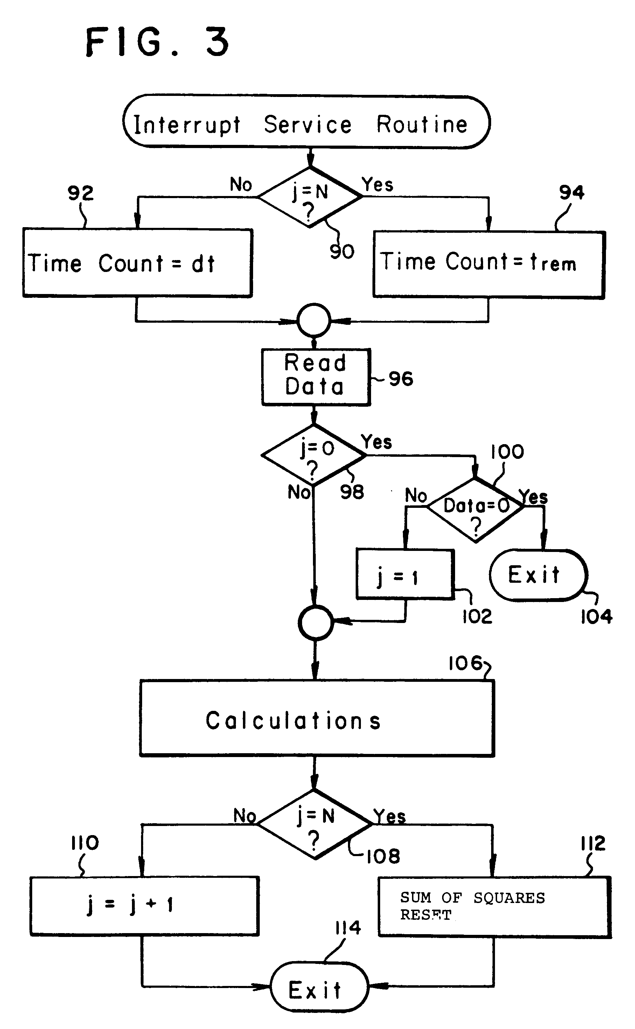

Random access memory (RAM) 50 and erasable programmable read only memory (EPROM) 52 provide the necessary memory for the operation of microcontroller 40. The software system which controls microcontroller 40 and which is depicted in flow diagram form in Figs. 2 and 3 and described in detail below is preferably stored in EPROM 52. RAM 50 is preferably used to store the running values of the different parameters measured and calculated as explained in detail below. RAM 50 and EPROM 52 are connected to microcontroller 40 via control lines 54 and data address bus 56. Microcontroller 40 contains, among other elements, an analog to digital (A/D) converter, a high speed input to output (I/O) port, and a timer. The A/D converter samples the input signal received on lines 32 and 34 at preselected time intervals, as discussed in detail below, and converts the input analog signal into a digital signal. This digital signal is then fed to the other elements of microcontroller 40.

The flow diagrams shown in Figs. 2 and 3 depict a software system which implements the one step RMS system of the present invention and is capable of measuring an RMS current. A hardware system as shown in Fig. 1 can be used to implement the software system shown in Figs. 2 and 3. In particular, the hardware system must have the capability to convert an analog signal to digital form, measure a pulse width, execute a time based interrupt, and perform the various mathematical calculations within the given time constraints. As previously discussed, an Intel MCS® 97 has these capabilities and has been disclosed as a typical hardware system.

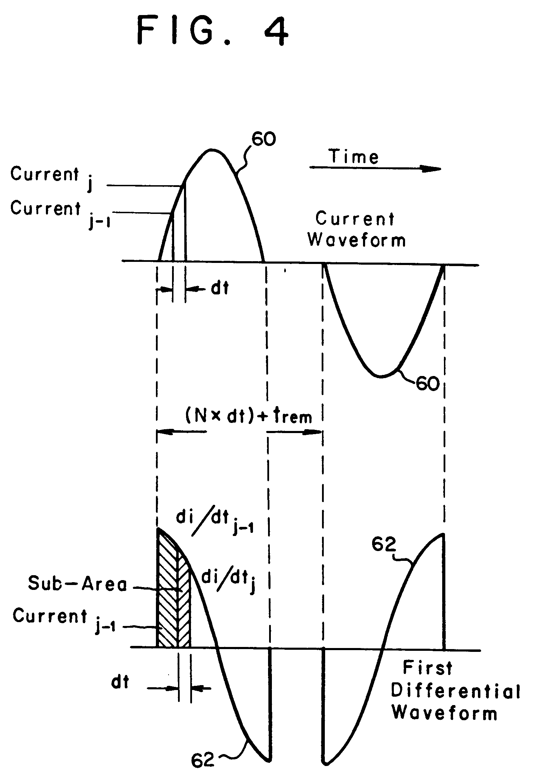

In Fig. 4, waveform 60 is an example of a current waveform plotted as a function of time. Although waveform 60 has a fixed known current frequency and a fixed known current period, other waveforms with unknown current frequencies and unknown current periods can be measured. The waveform produced by air core toroid coil 30 is shown as waveform 62. Waveform 62 is thus the first differential with respect to time of waveform 60. By sampling the magnitude of waveform 62 through the A/D converter of microcontroller 40, the software will calculate the RMS value of waveform 60 at predetermined intervals each of which is illustratively equal to one half current period or one pulse period which, as discussed below, is equal to (N x dt) + $t_{rem}$. The system described here samples waveform 62 at fixed time intervals dt. Every time waveform 62 is sampled, the software system calculates the current value at that time ($CURRENT_j$) and adds the square of the current to a running sum ($TOTAL_j$). The number N of samples taken determines the accuracy of the system. The specific calculations used to determine the RMS current are described in detail with reference to the flow diagrams of Figs. 2 and 3.

The flow diagram shown in Fig. 2 represents a preferred software system which is used to initialize the RMS system of the present invention. This initialization is necessary only at power up time, and does not need to be implemented every time an RMS measurement is calculated. Block 70 measures the width of one half cycle of the power line base frequency. This can be done easily using the high speed I/O port of microcontroller 40 coupled to zero detector 46 which outputs a pulse of time width equal to one half cycle. The time of a pulse period or one half current cycle allows microprocessor 40 to determine the base frequency of the power signal on power lines 12 (and therefore that of the current in secondary circuit 16) to be measured.

In decision block 72, it is determined whether the current frequency is 60 Hz or 50 Hz. Other frequencies can be accommodated with suitable changes in the software which would be obvious to those skilled in the art. In addition, the software can be modified so that the measurement of current in secondary circuit 16 is independent of the frequency or shape of the current waveform as discussed in greater detail below. Block 74 initializes the time base dependent variables for 60 Hz operation, while analogously block 76 does the same for 50 Hz operation. In particular, these variables are: the number of samples N to be taken per pulse period or one half cycle, and an associated remainder time ($t_{rem}$) for the particular operation frequency. N is determined based on a fixed sampling time interval dt of 100 microseconds. The remainder time $t_{rem}$ is used to ensure that the system is synchronized with the incoming waveform 60 and 62. Thus, in the case of 50 Hz operation, N is set equal to 99 and $t_{rem}$ is set equal to 100 us. This choice of N and $t_{rem}$ is made to match the duration of a pulse period which is equal to: (N x dt) + $t_{rem}$ = (99 x 100 us) + 100 us = 10,000 us. Although the duration of a one half cycle or pulse period (10,000 us) is equally divisible by dt = 100 us if N = 100 thus making it unnecessary to use $t_{rem}$, a value of 99 is chosen for N and a value of 100 us is chosen for $t_{rem}$ so that a $t_{rem}$ is required. This requirement allows the subroutine to be easily converted to operate for different current or corresponding power line frequencies as will become more apparent from the following description.

For 60 Hz operation, a value for $t_{rem}$ is necessary because the duration of one half cycle (8333 us) is not evenly divisible by dt + 100 us. In order to keep the system synchronized to 60 Hz, the last sampling time is stretched to 133 us. This choice of N and $t_{rem}$ results in a total one half cycle time or pulse period of (82 x 100 us) + 133 us = 8333 us. In fact, N could be chosen as 83 and a remainder time of 33 us could be used, but this choice of N and $t_{rem}$ would result in the processor having to be able to complete sample

EP 0 256 183 B1

calculations in a shortened time period of 33 us. By using N = 82, this time constraint is loosened, and the processor is given more than 100 us to complete all necessary calculations. The appropriate values of N and $t_{rem}$ are then preferably stored in RAM 50 for later use by microcontroller 40. For other operating frequencies, other values of N and $t_{rem}$ can be chosen.

In variable initialization block 78, the variables used in the main program are initialized by setting their values equal to zero and preferably storing these values in RAM 50. These variables are: $TOTAL_0$, the running sum of the squares of the current; $CURRENT_0$, the value of the current waveform at time zero; j, the counter used to keep track of the number of samples already taken of the waveform during a one half cycle; and $di/dt_0$, the value of the first differential waveform 62 at time zero.

Block 80 represents enabling the time based interrupt for the first time. This interrupt is determined by the timer and the I/O port of microcontroller 40. The timer is a counter that is always running in microcontroller 40. The software sets up an interrupt based on the count in the timer. When the timer reaches the specified count, an interrupt occurs. By reading the count in the timer and then adding some offset to that count, a relative time based interrupt is generated. The interrupt enabled in block 80 will be generated 100 us from the time it was enabled.

The initialization routine is complete once the timer interrupt is enabled. The interrupt service routine for the timer interrupt enables the next timer interrupt and handles all calculations involved in determining the RMS current. Because this system is interrupt controlled, a foreground task such as keeping statistics on the values of RMS current, or display of data can be implemented. The offpage reference block 82 in Fig. 2 represents entry into such a foreground task.

The flow diagram shown in Fig. 3 represents the interrupt service routine for the time based interrupt. Every time the interrupt is generated, data is sampled from air core toroid coil 30 and possibly used in calculations as explained in detail below.

The first step in the interrupt service routine as shown in Fig. 3 is to enable the next interrupt. Decision 90 determines whether j = N. If j is equal to N, this interrupt is the last interrupt, and therefore the last sample of data for one half cycle is currently being measured. This condition indicates that the next interrupt should be enabled with time count equal to $t_{rem}$. This ensures that the processor stays synchronized with the one half cycle time of current waveform 60. Block 94 represents this action. Block 92 is for the case when j is not equal to N. The time based interrupt is enabled for time count = dt which is equal to 100 us. This means that the next interrupt will occur at a time 100 us after the previous interrupt occurred.

Block 96 represents the process of sampling the data from air core toroid coil 30. This process is accomplished by converting the analog value from coil 30 into digital form using the A/D converter of microcontroller 40. Once the conversion is complete, the data is read from the A/D converter into system RAM 50.

Blocks 98, 100, 102 and 104 of Fig. 3 implement the startup of the measuring system. The program waits until a significant, non-zero, value is read from air core toroid coil 30 to start the measuring process. By doing this, the one half cycle measurement process is synchronized to the beginning of the current pulse.

Decision block 98 checks whether the measuring process has already begun. If the process has not yet begun (j = 0), decision block 100 determines whether the value of data just read from air core toroid coil 30 should start the process. If the value of the data read is equal to zero, the current pulse has not yet started and exit 104 returns control of the processor to the foreground routine. If the value of the data read is not equal to zero, the measuring process begins. This is shown in block 102 by assigning the value of 1 to j in RAM 50. This means that detection of the first significant data value from air core toroid coil 30 during the present one half cycle has occurred.

At block 106 the actual calculations are performed every time data is sampled from air core coil 30 during the measuring process. The value of the DATA read from the coil is assigned to $di/dt_j$:

$$di/dt_j = DATA$$

This is the value of the differential waveform 62 at time j x dt and is preferably stored in RAM 50 for later processing. Next, the area $SUB\text{-}AREA_j$, as shown in Fig. 4, between j x dt and (j-1) x dt and below the differential waveform 62 is approximated by mathematical integration as follows:

$$SUB\text{-}AREA_j = [(di/dt_j + di/dt_{j-1})/2] \times dt$$

This value is preferably stored in RAM 50 and is added to the value of $CURRENT_{j-1}$ at time (j-1) x dt, previously calculated, as follows:

6

$$CURRENT_j = CURRENT_{j-1} + SUB\text{-}AREA_j$$

This value is preferably stored in RAM 50 to be used the next time through the process. Finally, the square of $CURRENT_j$ is added to the value to $TOTAL_{j-1}$, to obtain $TOTAL_j$ which is a running sum of the squares of the CURRENT as follows:

$$TOTAL_j = TOTAL_{j-1} + [CURRENT_j]^2$$

The value of $TOTAL_j$ is then preferably stored in RAM 50.

When the first significant data value from air core toroid coil 30 has been detected for a new one half cycle as indicated in Fig. 3 at block 102 where a value of 1 is assigned to j, in block 106, since j = 1, SUB-AREA$_1$ is calculated as follows:

$$\begin{aligned}
\textbf{SUB-AREA}_1 &= [(di/dt_1 + di/dt_0)/2] \times dt \\
&= [(di/dt_1 + 0)/2] \times dt \\
&= [(di/dt_1)/2] \times dt
\end{aligned}$$

Decision 108 then determines whether all N values for the waveform being measured have been processed which has occurred when j is equal to N. If j is not equal to N, then as block 110 shows, j is incremented by one and control of the processor is returned to the foreground routine. As previously explained, the processing of the foreground routine is interrupted at an interrupt time as set in blocks 92 or 94. When the foreground routine is interrupted, the interrupt service routine is processed beginning at block 90.

If j is equal to N, then all measurements for the waveform have been processed. The final calculation is made in block 112 to determine the RMS current by taking the sum of the squares of the currents $TOTAL_j$ which is equal to $TOTAL_n$, dividing TOTAL by N, and taking the square root of the result. This calculation results in a value for the RMS current $I_{RMS}$:

$$I_{RMS} = (TOTAL_N/N)^{1/2}$$

In block 112, the variables are also reset and reinitialized to zero for measurements in the next one half cycle. In particular, j, TOTAL, CURRENT, and di/dt are all set equal to zero and these values are stored in RAM 50. At this point, control of the processor is returned to the foreground routine as discussed above, the RMS current is displayed on digital display 48, and the next measurements on the next one half cycle will commence once the next non-zero data value is read from air core coil 30.

While the invention has been described in conjunction with specific embodiments, it is evident that numerous alternatives, modifications, variations, and uses will be apparent to those skilled in the art in light of the forgoing description. For example, the time between samplings dt can be changed to achieve higher or lower sampling rates depending upon the particular waveform to be measured, thus allowing the measurement of RMS values for a wide variety of waveforms. RMS values of waveforms of different frequencies can be measured by choosing the appropriate values for N and $t_{rem}$.

The software program used to implement the RMS system of the present invention can also be easily modified to obtain RMS values of current waveforms with only a single pulse, or waveforms comprised of several different pulses with different durations. For example, the current waveform can comprise three pulses, (which may or may not be repeated periodically), where the first pulse has a positive polarity and a duration of 0.5 seconds, the second pulse has a negative polarity and a duration of 1.0 seconds, and the third pulse has a positive polarity and a durtion of 0.5 seconds. Although this current waveform is a balanced waveform of several pulses, it is not symmetrically periodic like waveform 60 shown in Fig. 4.

Additionally, as mentioned above, the initialization software described in the flow diagram of Figure 2 can be modified so that the measurement of the current in secondary circuit 16 is independent of the frequency or shape of the current waveform. This modification is useful, for example, when the current waveform to be measured is comprised of pulses which are equal to or greater than one half cycle of the power line frequency. If the waveform to be measured were comprised of pulses of several seconds in duration, it would be desirable to determine the RMS current more frequently than once for every pulse since more frequent monitoring of the RMS current may be desired. In such a case, the software in effect breaks the long pulses into segments and determines the RMS current for each segment. This can be accomplished by choosing particular values for N and $t_{rem}$ which do not necessarily depend upon the shape or frequency of the current waveform. Additionally, the interrupt service routine described in the flow diagram of Figure 3 can then optionally be modified so that the RMS values determined for all of the segments of the long pulses are averaged to obtain the average RMS value for the each long pulse. Such a modification of the software permits the measurement of RMS current values for waveforms commonly found in frequency converters and "DC" welders. Since these machines have current pulses with durations that are longer than those of single phase welders, the above described modification of the software to measure segments of the pulses permits the measurement of RMS current values of these pulses even though the pulse duration may be arbitrary and may vary from one pulse to another.

**Claims**

1. Apparatus for determining the root mean square value of a pulsatile signal generated from a power line signal, said power line signal having a known substantially fixed period, and wherein the absolute value of said pulsatile signal has a period substantially equal to half the period of said power line signal and a time duration equal to less than said half period, said apparatus characterized by:

   means (96) for producing samples of the pulsatile signal at predefined substantially equal sampling intervals beginning at substantially the onset of a pulse in said pulsatile signal and continuing thereafter for substantially the entire duration of said half period of said power line signal to generate corresponding sampled values;

   means (106) responsive to said sample producing means for squaring each of said sampled values to generate corresponding squared values;

   means (106) operative in response to said squaring means for accumulating each of said squared values to produce a totalized value;

   means (106) responsive to said squaring means for dividing said totalized value by a number, wherein said number equals the total number of separate samples taken and accumulated during said half period to yield an intermediate value; and

   means (106), responsive to said dividing means, for determining the square root of said intermediate value to yield said root mean square value of said pulsatile signal.

2. The apparatus in claim 1 further characterized by:

   means (70) for ascertaining the period of said power line signal; and

   means (72) for choosing a duration of said sampling interval to provide a desired resolution in said root mean square value.

3. The apparatus in claim 2 characterized in that said squaring means generates each squared value prior to the occurrence of each corresponding successively occurring sampled value, and said accumulating means adds each squared value to the totalized value prior to the occurrence of said next successively occurring sampled value.

4. The apparatus in claim 3 characterized in that said apparatus further comprises an air core pickup coil (30) for providing said pulsatile signal, wherein said pulsatile signal is proportional to a first derivative of a measured current; and said sample producing means further comprises:

   means for sampling said pulsatile signal, at predefined substantially equal sampling intervals beginning at substantially the onset of a pulse in said pulsatile signal and continuing thereafter for substantially the entire duration of said half period of said power line signal, to yield corresponding digital values; and

   means for integrating each of said digital values to yield each of said sampled values, wherein each of said sampled values is proportional to an instantaneous value of said measured current.

5. The apparatus in claim 4 characterized in that said sampling interval has a duration of approximately 100 microseconds and said number equals the value 82 in the event said power line signal has a frequency of approximately 60 Hertz.

6. The apparatus in claim 4 characterized in that said sampling interval has a duration of approximately 100 microseconds, and said number equals the value 99 in the event said power line signal has a frequency of approximately 50 Hertz.

7. Apparatus as claimed in claim 1 characterized in that the apparatus further includes an air pickup coil (30) for providing said samples of said pulsatile signal, said pulsatile signal being proportional to a first derivative of measured welding current, said apparatus determining the root mean square of said measured welding current.

8. A method for determining the root means square value of a pulsatile signal generated from a power line signal, said power line signal having a known substantially fixed period, and wherein said pulsatile signal has an absolute value and the absolute value has a period substantially equal to half the period of said power line signal and a time duration equal to less than said half period, said method characterized by the steps of:

producing samples of the pulsatile signal at predefined substantially equal sampling intervals beginning at substantially the onset of a pulse in said pulsatile signal and continuing thereafter for substantially the entire duration of said half period of said power line signal to generate corresponding sampled values;

squaring each of said sampled values to generate corresponding squared values;

accumulating each of said squared values to produce a totalized value;

dividing said totalized value by a number, wherein said number equals the total number of separate samples taken an accumulated during said half period to yield an intermediate value; and

determining the square root of said intermediate value to yield said root mean square value of said pulsatile signal.

9. The method in claim 8 further characterized by the steps of:

ascertaining the period of said power line signal; and choosing a duration of said sampling interval to provide a desired resolution in said root mean square value.

10. The method in claim 9 characterized in that said squaring step further comprises the step of generating each squared value prior to the occurrence of each corresponding successively occurring sampled value; and said accumulating step further comprises the step of adding each squared value to the totalized value prior to the occurrence of said next successively occurring sampled value.

11. The method in claim 10 further characterized by the step of generating said pulsatile signal using an air core pickup coil, wherein said pulsatile signal generated by said coil is proportional to a first derivative of a measured current; and said sample method further comprises:

sampling said pulsatile signal, at predefined substantially equal sampling intervals beginning at substantially the onset of a pulse in said pulsatile signal and continuing thereafter for the entire duration of said half period of said power line signal, to yield corresponding digital values; and

integrating each of said digital values to yield each of said sampled values, wherein each of said sampled values is proportional to an instantaneous value of said measured current.

12. The method in claim 11 characterized by said sampling interval has a duration of approximately 100 microseconds, and said number equals the value of 82 in the event said power line signal has a frequency of approximately 60 Hertz.

13. The method in claim 11 characterized by said sampling interval has a duration of approximately 100 microseconds and said number equals the value 99 in the event said power line signal has a frequency of approximately 50 Hertz.

14. A method as claimed in claim 11 characterized in that said method includes the step of generating said pulsatile signal using an air core pickup coil, said pulsatile signal generated being proportional to a first derivative of a pulsatile welding current, whereby the method determines the root mean square of said welding current.

**Patentansprüche**

1. Vorrichtung zum Bestimmen des Effektivwertes eines durch ein Netzleitungssignal erzeugten pulsierenden Signals, wobei das Netzleitungssignal eine bekannte, im wesentlichen feste Periode aufweist und wobei der Absolutwert des pulsierenden Signals eine Periode, die im wesentlichen gleich der Hälfte der Periode des Netzleitungssignals ist, und eine Zeitdauer aufweist, die weniger als die halbe Periode beträgt, wobei die Vorrichtung gekennzeichnet ist durch:

eine Einrichtung (96) zum Erzeugen von Abtastungen des pulsierenden Signals in vorgegebenen im wesentlichen gleichen Abtastintervallen beginnend im wesentlichen am Beginn eines Impulses des pulsierenden Signals und danach fortlaufend für im wesentlichen die gesamte Dauer der halben Periode des Netzleitungssignals, um entsprechende abgetastete Werte zu erzeugen;

eine auf die die Abtastungen erzeugende Einrichtung ansprechende Einrichtung (106) zum Quadrieren jedes Abtastwertes, um entsprechende quadrierte Werte zu erzeugen;

eine in Antwort auf die Quadriereinrichtung arbeitende Einrichtung (106) zum Akkumulieren jeder der quadrierten Werte, um einen Summenwert zu erzeugen;

eine auf die Quadriereinrichtung ansprechende Einrichtung (106) zum Dividieren des Summenwertes durch einen Zahlenwert, wobei der Zahlenwert gleich der Gesamtanzahl der während der halben Periode durchgeführten separaten Abtastungen ist, um einen Mittelwert zu erhalten; und

eine auf die Dividiereinrichtung ansprechende Einrichtung (106) zum Bestimmen der Quadratwurzel des Mittelwertes, um den Effektivwert des pulsierenden Signals zu erhalten.

2. Vorrichtung nach Anspruch 1, ferner gekennzeichnet durch:

eine Einrichtung (70) zum Feststellen der Periode des Netzleitungssignals; und

eine Einrichtung (72) zum Auswählen einer Zeitdauer des Abtastintervalls, um eine gewünschte Auflösung des Effektivwertes zu erhalten.

3. Vorrichtung nach Anspruch 2, dadurch gekennzeichnet, daß

die Quadriereinrichtung jeden quadrierten Wert vor dem Auftreten jedes entsprechenden sukzessiv auftretenden Abtastwertes erzeugt und die Akkumuliereinrichtung jeden quadrierten wert zum Gesamtwert addiert, bevor der nächste sukzessiv auftretende Abtastwert auftritt.

4. Vorrichtung nach Anspruch 3, dadurch gekennzeichnet, daß die Vorrichtung ferner aufweist:

eine eisenlose Sondenspule (30) zum Erzeugen des pulsierenden Signals, wobei das pulsierende Signal einer ersten Ableitung eines gemessenen Stromes proportional ist; und wobei die die Abtastungen erzeugende Einrichtungen ferner aufweist:

eine Einrichtung zum Abtasten des pulsierenden Signals in vorgegebenen im wesentlichen gleichen Abtastintervallen beginnend im wesentlichen am Beginn eines Impulses des pulsierenden Signals und danach fortlaufend für im wesentlichen die gesamte Dauer der halben Periode des Netzleitungssignals, um entsprechende digitale Werte zu erzeugen; und

eine Einrichtung zum Integrieren jedes der digitalen Werte, um jeden der abgetasteten Werte zu erhalten, wobei jeder der abgetasteten Werte einem Momentanwert des gemessenen Stromes proportional ist.

5. Vorrichtung nach Anspruch 4, dadurch gekennzeichnet, daß das Abtastintervall eine Dauer von etwa 100 Mikrosekunden und der Zahlenwert den Wert 82 besitzt, wenn das Netzleitungssignal eine Frequenz von etwa 60 Hertz aufweist.

6. Vorrichtung nach Anspruch 4, dadurch gekennzeichnet, daß das Abtastintervall eine Dauer von etwa 100 Mikrosekunden und der Zahlenwert den Wert 99 besitzt, wenn das Netzleitungssignal eine Frequenz von etwa 50 Hertz aufweist.

7. Vorrichtung nach Anspruch 1, dadurch gekennzeichnet, daß die Vorrichtung ferner eine eisenlose Sondenspule (30) zum Erzeugen der Abtastungen des pulsierenden Signals aufweist, wobei das pulsierende Signal einer ersten Ableitung eines gemessenen Schweißstromes proportional ist, wobei die Vorrichtung den Effektivwert des gemessenen Schweißstromes bestimmt.

8. Verfahren zum Bestimmen des Effektivwertes eines durch ein Netzleitungssignal erzeugten pulsierenden Signals, wobei das Netzleitungssignal eine bekannte, im wesentlichen feste Periode aufweist und wobei das pulsierende Signal einen Absolutwert aufweist, der eine Periode besitzt, die im wesentlichen gleich der Hälfte der Periode des Netzleitungssignals ist, und eine Zeitdauer aufweist, die weniger als die halbe Periode ist, wobei das Verfahren gekennzeichnet ist durch die Schritte:

Erzeugen von Abtastungen des pulsierenden Signals in vorgegebenen im wesentlichen gleichen Abtastintervallen beginnend im wesentlichen am Beginn eines Impulses des pulsierenden Signals und danach fortlaufend für im wesentlichen die gesamte Dauer der halben Periode des Netzleitungssignals, um entsprechende abgetastete Werte zu erzeugen;

Quadrieren jedes Abtastwertes, um entsprechende quadrierte Werte zu erzeugen;

Akkumulieren jeder der quadrierten Werte, um einen Summenwert zu erzeugen;

Dividieren des Summenwertes durch einen Zahlenwert, wobei der Zahlenwert gleich der Gesamtanzahl der während der halben Periode durchgeführten separaten Abtastungen ist, um einen Mittelwert zu erhalten; und

Bestimmen der Quadratwurzel des Mittelwertes, um den Effektivwert des pulsierenden Signals zu erhalten.

9. Verfahren nach Anspruch 8, ferner gekennzeichnet durch die Schritte:

Feststellen der Periode des Netzleitungssignals; und

Auswählen einer Zeitdauer des Abtastintervalls, um eine gewünschte Auflösung des Effektivwertes zu erhalten.

10. Verfahren nach Anspruch 9, dadurch gekennzeichnet, daß

der Quadrierungsschritt außerdem den Schritt aufweist: Erzeugen jedes quadrierten Wertes vor dem Auftreten jedes entsprechenden sukzessiv auftretenden Abtastwertes; und der Akkumulierungsschritt außerdem den Schritt aufweist: Addieren jedes quadrierten Wertes zum Gesamtwert, bevor der nächste sukzessiv auftretende Abtastwert auftritt.

11. Verfahren nach Anspruch 10, ferner durch den Schritt gekennzeichnet:

Erzeugen des pulsierenden Signals unter Verwendung einer eisenlosen Sondenspule, wobei das durch die Spule erzeugte pulsierende Signal einer ersten Ableitung eines gemessenen Stromes proportional ist; und wobei der Schritt zum Erzeugen der Abtastungen ferner aufweist:

Abtasten des pulsierenden Signals in vorgegebenen im wesentlichen gleichen Abtastintervallen beginnend im wesentlichen am Beginn eines Impulses des pulsierenden Signals und danach fortlaufend für im wesentlichen die gesamte Dauer der halben Periode des Netzleitungssignals, um entsprechende digitale Werte zu erzeugen; und

Integrieren jedes der digitalen Werte, um jeden der abgetasteten Werte zu erhalten, wobei jeder der abgetasteten Werte einem Momentanwert des gemessenen Stromes proportional ist.

12. Verfahren nach Anspruch 11, dadurch gekennzeichnet, daß das Abtastintervall eine Dauer von etwa 100 Mikrosekunden und der Zahlenwert den Wert 82 besitzt, wenn das Netzleitungssignal eine Frequenz von etwa 60 Hertz aufweist.

13. Verfahren nach Anspruch 11, dadurch gekennzeichnet, daß das Abtastintervall eine Dauer von etwa 100 Mikrosekunden und der Zahlenwert den Wert 99 besitzt, wenn das Netzleitungssignal eine Frequenz von etwa 50 Hertz aufweist.

14. Verfahren nach Anspruch 11, dadurch gekennzeichnet, daß das Verfahren ferner den Schritt aufweist: Erzeugen des pulsierenden Signals unter Verwendung einer eisenlosen Sondenspule, wobei das erzeugte pulsierende Signal einer ersten Ableitung eines pulsierenden Schweißstromes proportional ist, wobei durch das Verfahren der Effektivwert des gemessenen Schweißstromes bestimmt wird.

**Revendications**

1. Appareil permettant de déterminer la valeur de moyenne quadratique d'un signal impulsionnel généré à partir d'un signal de ligne d'alimentation, ledit signal de ligne d'alimentation présentant une période sensiblement fixe connue, et dans lequel la valeur absolue dudit signal impulsionnel présente une période sensiblement égale à la moitié de la période dudit signal de ligne d'alimentation et une durée temporelle égale à moins que ladite demi-période, ledit appareil étant caractérisé par :

un moyen (96) pour produire des échantillons du signal impulsionnel selon des intervalles d'échantillonnage sensiblement égaux prédéfinis commençant sensiblement lors de l'attaque d'une impulsion dudit signal impulsionnel et se poursuivant après pendant sensiblement la totalité de la durée de ladite demi-période dudit signal de ligne d'alimentation pour générer des valeurs échantillonnées correspondantes ;

un moyen (106) sensible audit moyen de production d'échantillons pour élever au carré chacune desdites valeurs échantillonnées pour générer des valeurs élevées au carré correspondantes ;

un moyen (106) sensible en réponse audit moyen d'élévation au carré pour accumuler chacune desdites valeurs élevées au carré pour produire une valeur totalisée ;

un moyen (106) sensible audit moyen d'élévation au carré pour diviser ladite valeur totalisée par un nombre, dans lequel ledit nombre est égal au nombre total d'échantillons séparés pris et accumulés pendant ladite demi-période pour obtenir une valeur intermédiaire ; et

un moyen (106) sensible audit moyen de division pour déterminer la racine carrée de ladite valeur intermédiaire pour obtenir ladite valeur de moyenne quadratique dudit signal impulsionnel.

2. Appareil selon la revendication 1, caractérisé en outre par :

un moyen (70) pour évaluer la période dudit signal de ligne d'alimentation ; et

un moyen (72) pour choisir une durée dudit intervalle d'échantillonnage pour produire une résolution souhaitée de ladite valeur de moyenne quadratique.

3. Appareil selon la revendication 2, caractérisé en ce que ledit moyen d'élévation au carré génère chaque valeur élevée au carré avant la survenue de chaque valeur échantillonnée se produisant successivement correspondante et ledit moyen d'accumulation additionne chaque valeur élevée au carré à la valeur totalisée avant la survenue de ladite valeur échantillonnée se produisant successivement ensuite.

4. Appareil selon la revendication 3, caractérisé en ce que ledit appareil comprend en outre une bobine exploratrice sans noyau (30) pour produire ledit signal impulsionnel, dans lequel ledit signal impulsionnel est proportionnel à une première dérivée d'un courant mesuré ; ledit moyen de production d'échantillons comprend en outre :

un moyen pour échantillonner ledit signal impulsionnel selon des intervalles d'échantillonnage sensiblement égaux prédéfinis commençant sensiblement lors de l'attaque d'une impulsion dudit signal impulsionnel et se poursuivant ensuite pendant sensiblement la totalité de la durée de ladite demi-période dudit signal de ligne d'alimentation pour obtenir des valeurs numériques correspondantes ; et

un moyen pour intégrer chacune desdites valeurs numériques pour obtenir chacune desdites valeurs échantillonnées, dans lequel chacune desdites valeurs échantillonnées est proportionnelle à une valeur instantanée dudit courant mesuré.

5. Appareil selon la revendication 4, caractérisé en ce que ledit intervalle d'échantillonnage présente une durée d'approximativement 100 microsecondes et ledit nombre est égal à la valeur 82 dans l'éventualité où ledit signal de ligne d'alimentation présente une fréquence d'approximativement 60 hertz.

6. Appareil selon la revendication 4, caractérisé en ce que ledit intervalle d'échantillonnage présente une durée d'approximativement 100 microsecondes et ledit nombre est égal à la valeur 99 dans l'éventualité où ledit signal de ligne d'alimentation présente une fréquence d'approximativement 50 hertz.

7. Appareil selon la revendication 1, caractérisé en ce que l'appareil inclut en outre une bobine exploratrice sans noyau (30) pour produire lesdits échantillons dudit signal impulsionnel, ledit signal impulsionnel étant proportionnel à une première dérivée d'un courant de soudage mesuré, ledit appareil déterminant la moyenne quadratique dudit courant de soudage mesuré.

8. Procédé de détermination de la valeur de moyenne quadratique d'un signal impulsionnel généré à partir d'un signal de ligne d'alimentation, ledit signal de ligne d'alimentation présentant une période sensiblement fixe connue, et dans lequel ledit signal impulsionnel présente une valeur absolue et la valeur absolue présente une période sensiblement égale à la moitié de la période dudit signal de ligne d'alimentation et une durée temporelle égale à moins que ladite demi-période, ledit procédé étant caractérisé par les étapes de :

production d'échantillons du signal impulsionnel selon des intervalles d'échantillonnage sensiblement égaux prédéfinis commençant sensiblement lors de l'attaque d'une impulsion dudit signal impulsionnel et se poursuivant après pendant sensiblement la totalité de la durée de ladite demi-période dudit signal de ligne d'alimentation pour générer des valeurs échantillonnées correspondantes ;

élévation au carré de chacune desdites valeurs échantillonnées pour générer des valeurs élevées au carré correspondantes ;

accumulation de chacune desdites valeurs élevées au carré pour produire une valeur totalisée ;

division de ladite valeur totalisée par un nombre, dans lequel ledit nombre est égal au nombre total d'échantillons séparés saisis et accumulés pendant ladite demi-période pour obtenir une valeur intermédiaire ; et

détermination de la racine carrée de ladite valeur intermédiaire pour obtenir ladite valeur de moyenne quadratique dudit signal impulsionnel.

9. Procédé selon la revendication 8, caractérisé en outre par les étapes de :

évaluation de la période dudit signal de ligne d'alimentation ; et

choix d'une durée dudit intervalle d'échantillonnage pour produire une résolution souhaitée de ladite valeur de moyenne quadratique.

10. Procédé selon la revendication 9, caractérisé en ce que ladite étape d'élévation au carré comprend en outre l'étape de génération de chaque valeur élevée au carré avant la survenue de chaque valeur échantillonnée se produisant successivement correspondante ; et ladite étape d'accumulation comprend en outre l'étape d'addition de chaque valeur élevée au carré à la valeur totalisée avant la survenue de ladite valeur échantillonnée se produisant successivement ensuite.

11. Procédé selon la revendication 10, caractérisé en outre par l'étape de génération dudit signal impulsionnel en utilisant une bobine exploratrice sans noyau, dans lequel ledit signal impulsionnel généré par ladite bobine est proportionnel à une première dérivée d'un courant mesuré ; et ledit l'étape de génération d'échantillons comprend en outre :

l'échantillonnage dudit signal impulsionnel selon des intervalles d'échantillonnage sensiblement égaux prédéfinis commençant sensiblement lors de l'attaque d'une impulsion dudit signal impulsionnel et se poursuivant ensuite pendant la totalité de la durée de ladite demi-période dudit signal de ligne d'alimentation pour obtenir des valeurs numériques correspondantes ; et

intégration de chacune desdites valeurs numériques pour obtenir chacune desdites valeurs échantillonnées, dans lequel chacune desdites valeurs échantillonnées est proportionnelle à une valeur instantanée dudit courant mesuré.

12. Procédé selon la revendication 11, caractérisé en ce que ledit intervalle d'échantillonnage présente une durée d'approximativement 100 microsecondes et ledit nombre est égal à la valeur 82 dans l'éventualité où ledit signal de ligne d'alimentation présente une fréquence d'approximativement 60 hertz.

13. Procédé selon la revendication 11, caractérisé en ce que ledit intervalle d'échantillonnage présente une durée d'approximativement 100 microsecondes et ledit nombre est égal à la valeur 99 dans l'éventualité où ledit signal de ligne d'alimentation présente une fréquence d'approximativement 50 hertz.

14. Procédé selon la revendication 11, caractérisé en ce que ledit procédé inclut l'étape de génération dudit signal impulsionnel en utilisant une bobine exploratrice sans noyau, ledit signal impulsionnel généré étant proportionnel à une première dérivée d'un courant de soudage impulsionnel et ainsi, le procédé détermine la moyenne quadratique dudit courant de soudage.

EP 0 256 183 B1

FIG. 1

Power Line

12

10

14

16

18  18

20

SCR Switch  22

SCR Drive  24

Welder Control  26

30  32  34

Ref.  42

Microcontroller  40

RAM  50

EPROM  52

54  56

Power Supply  44

Power Line

Zero Detector  46

Digital Display  48

14

# FIG. 2

Initialization

Pulse Width Detector — 70

72

FREQUENCY OF ELECTRODE CURRENT 50 OR 60 HZ

NO

Yes

74

60 Hz
N = 82
$t_{rem}$ = 133 US

76

50 Hz
N = 99
$t_{rem}$ = 100 US

78

Variable Initialization
TOTAL = 0; SAMPLE COUNTER (j=o)

CURRENT = 0; $di/dt_o$ = 0

80

Enable Timer Interrupt

82

# FIG. 3

Interrupt Service Routine

j=N? — 90

92 — Time Count = dt

94 — Time Count = t$_{rem}$

Read Data — 96

j=0? — 98

100 — Data=0?

j=1 — 102

Exit — 104

Calculations — 106

j=N? — 108

110 — j = j+1

112 — SUM OF SQUARES RESET

Exit — 114

# F I G . 4